(19) **Europäisches Patentamt / European Patent Office / Office européen des brevets**

(11) **EP 4 693 129 A1**

(12) **EUROPEAN PATENT APPLICATION**
published in accordance with Art. 153(4) EPC

(43) Date of publication:
**11.02.2026 Bulletin 2026/07**

(21) Application number: **24778643.7**

(22) Date of filing: **30.01.2024**

(51) International Patent Classification (IPC):
**G06Q 10/0631** *(2023.01)* **E02F 9/00** *(2006.01)*
**G06Q 50/08** *(2012.01)*

(52) Cooperative Patent Classification (CPC):
**E02F 9/00; G06Q 10/0631; G06Q 50/08; G06Q 50/10**

(86) International application number:
**PCT/JP2024/002808**

(87) International publication number:
**WO 2024/202497 (03.10.2024 Gazette 2024/40)**

(84) Designated Contracting States:
**AL AT BE BG CH CY CZ DE DK EE ES FI FR GB GR HR HU IE IS IT LI LT LU LV MC ME MK MT NL NO PL PT RO RS SE SI SK SM TR**
Designated Extension States:
**BA**
Designated Validation States:
**GE KH MA MD TN**

(30) Priority: **31.03.2023 JP 2023058875**

(71) Applicant: **Hitachi Construction Machinery Co., Ltd.**
**Tokyo 110-0015 (JP)**

(72) Inventors:
- **YAMAZOE Takanori**
  **Tokyo 100-8280 (JP)**
- **KOMATSU Daiki**
  **Tokyo 100-8280 (JP)**
- **TAKEUCHI Ken**
  **Tokyo 110-0015 (JP)**
- **KAMIJOU Takashi**
  **Tokyo 110-0015 (JP)**
- **WATANABE Akira**
  **Tokyo 110-0015 (JP)**

(74) Representative: **MERH-IP Matias Erny Reichl Hoffmann**
**Patentanwälte PartG mbB**
**Paul-Heyse-Straße 29**
**80336 München (DE)**

(54) **OPERATION ASSISTANCE DEVICE AND OPERATION ASSISTANCE METHOD FOR ELECTRIC WORK MACHINE**

(57) This disclosure provides an operation assistance device capable of suppressing degradation and increasing a life of battery of an electric work machine. An operation assistance device 1 allocates a plurality of electric work machines EWM1, EWM2, ..., EWMn to a respective plurality of work sites WS1, WS2, ..., WSn. The operation assistance device 1 includes an information storing section 11 that stores each piece of information on a workload of the plurality of work sites WS, a state acquiring section 12 that acquires a degradation state of a battery B mounted in each of the electric work machines EWM, a state predicting section 13 that calculates a predicted degradation state of the battery B when each of the electric work machines EWM works at each of the work sites WS, and an operation planning section 14. The operation planning section 14 selects the work sites WS in a descending order of the workload based on the information stored by the information storing section 11, and allocates a specific electric work machine EWM among the plurality of electric work machines EWM1, EWM2, ..., EWMn to the selected work site WS based on the predicted degradation state.

EP 4 693 129 A1

# Fig. 1A

# EP 4 693 129 A1

**Description**

Technical Field

The disclosure relates to an operation assistance device and an operation assistance method for an electric work machine.

Background Art

Conventionally, there has been known an invention relating to a power supply system of a construction machinery including an electric motor driven by a battery (see Patent Literature 1 below). The power supply system of the construction machinery described in Patent Literature 1 includes a plurality of towed vehicles, at least one construction machinery, a charging facility, at least one haulage vehicle, and a computer (paragraph 0009, and claim 1).

Each of the plurality of towed vehicles includes a battery. The at least one construction machinery tows one of the plurality of towed vehicles, and includes an electric motor driven by the electric power of the battery of the towed vehicle and a hydraulic pump driven by the electric motor. The charging facility is a facility for charging the batteries mounted in the plurality of towed vehicles.

The at least one haulage vehicle tows a charged towed vehicle charged at the charging facility among the plurality of towed vehicles to the vicinity of any of the at least one or more construction machineries, and tows the towed vehicle towed by the construction machinery to the charging facility instead of the charged towed vehicle.

The computer predicts the number of times of changing the towed vehicles that at least one construction machinery changes in a predetermined period and each change time based on a workload plan in the predetermined period of the construction machinery. The computer further calculates a time at which at least one haulage vehicle arrives at the vicinity of the construction machinery with the charged towed vehicle so as to be in time for each change time.

Citation List

Patent Literature

Patent Literature 1: JP 2016-084633 A

Summary of Invention

Technical Problem

According to the conventional power supply system of the construction machinery, since the battery change time can be estimated based on the workload plan of the construction machinery, the operation efficiency of the construction machinery and the usage efficiency of the battery can be improved (Patent Literature 1, paragraph 0010). However, the conventional system does not consider the variation in progress of battery degradation in each construction machinery, and therefore, there is a room for improving the suppression of the degradation and the increase of the life of the battery.

The present disclosure provides an operation assistance device and an operation assistance method for an electric work machine capable of suppressing degradation and increasing life of a battery in the electric work machine.

Solution to Problem

One aspect of the disclosure is an operation assistance device comprising a server that allocates a plurality of electric work machines to a plurality of work sites. The server includes an information storing section, a state acquiring section, a state predicting section, and an operation planning section. The information storing section stores each piece of information on a workload of the plurality of work sites. The state acquiring section acquires a degradation state of a battery mounted in each of the plurality of electric work machines. The state predicting section calculates a predicted degradation state of the battery when each of the plurality of electric work machines works at any of the plurality of work sites. The operation planning section selects the work sites in a descending order of the workload based on the information on the workload stored in the information storing section, and allocates a specific electric work machine among the plurality of electric work machines to the work site in the selected order based on the degradation state of the battery acquired by the state acquiring section and the predicted degradation state of the battery calculated by the state predicting section.

Advantageous Effects of Invention

The operation assistance device for an electric work machine capable of suppressing degradation and increasing life of the battery in the electric work machine can be provided.

Brief Description of Drawings

Fig. 1A is a schematic diagram illustrating Embodiment 1 of an operation assistance device according to the disclosure.
Fig. 1B is a flowchart illustrating an exemplary operation of the operation assistance device illustrated in Fig. 1A.
Fig. 2 is a flowchart describing Embodiment 2 of a driving assistance system according to the disclosure.
Fig. 3 is a flowchart describing Embodiment 3 of the driving assistance system according to the disclosure.
Fig. 4 is a flowchart describing Embodiment 4 of the driving assistance system according to the disclosure.
Fig. 5 is a flowchart describing Embodiment 5 of the driving assistance system according to the disclosure.

Description of Embodiments

The following describes embodiments of an operation assistance device and an operation assistance method for an electric work machine according to the disclosure with reference to the drawings.

[Embodiment 1]

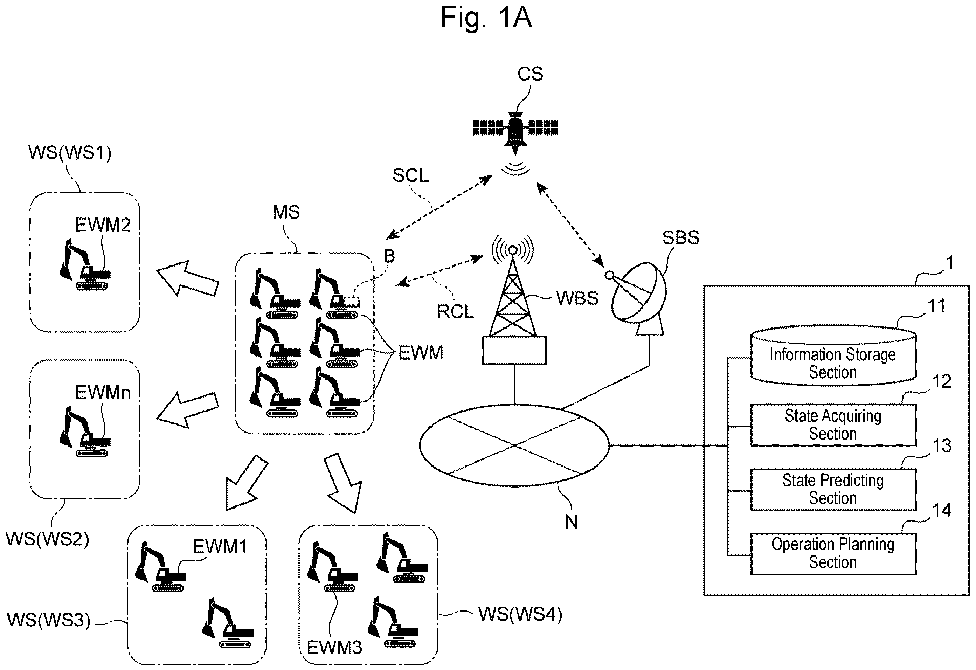

Fig. 1A is a schematic diagram illustrating Embodiment 1 of an operation assistance device for an electric work machine according to the disclosure. An operation assistance device 1 of the embodiment is, for example, a server configured of a computer including a central processing unit (CPU) and a storage device (not illustrated) and connected to a network N, such as Internet. The operation assistance device 1 is a device that allocates a plurality of electric work machines EWM1, EWM2, ..., EWMn to a respective plurality of work sites WS1, WS2, ..., WSn.

Each of the electric work machines EWM, for example, includes a battery B, and generates a driving force by rotating a motor with an electric power stored in the battery B. The plurality of electric work machines EWM1, EWM2, ..., EWMn include, for example, at least one of an electric hydraulic excavator, an electric dump truck, or an electric material handling machine. The plurality of electric work machines EWM1, EWM2, ..., EWMn before allocated to the respective work sites WS by the operation assistance device 1 wait at, for example, a machine station MS.

Each of the electric work machines EWM includes, for example, a communication device (not illustrated), such as a wireless communication device or a satellite communication device, and a controller (not illustrated) that calculates a degradation state of the battery B. As the degradation state of the battery B, for example, a "State of Health: SOH" that is a ratio of a full charge capacity at degradation to a full charge capacity at early stage of the battery B can be used. The degradation state SOH of the battery B is expressed as a percentage having the full charge capacity at early stage as 100, and decreases when the battery B degrades. The degradation state SOH may be calculated, for example, based on a charge/discharge capacity of the battery B during operation of the electric work machine EWM and a charge capacity of the battery B charged by a charging device.

The communication device mounted in each electric work machine EWM is, for example, connected to the operation assistance device 1 so as to be able to communicate information via a wireless communication line RCL including a wireless base station WBS or a satellite communication line SCL including a communication satellite CS and a satellite base station SBS, and a network N. The controller mounted in each electric work machine EWM transmits, for example, the degradation state SOH of battery B mounted in each electric work machine EWM to the operation assistance device 1 via the communication device mounted in each electric work machine EWM.

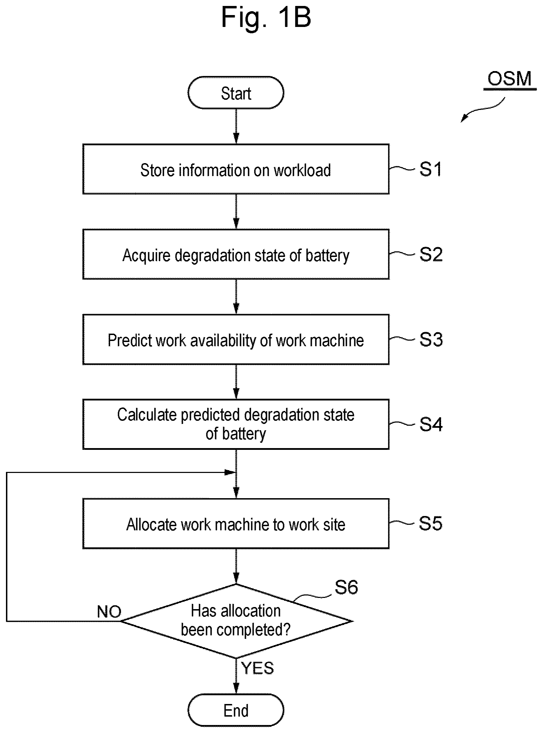

The operation assistance device 1 includes, for example, an information storing section 11, a state acquiring section 12, a state predicting section 13, and an operation planning section 14. The respective sections of the operation assistance device 1 indicate functions of the operation assistance device 1, for example, achieved by the CPU of the operation assistance device 1 executing the program stored in the storage device of the operation assistance device 1. The following describes an operation of the operation assistance device 1 of the embodiment and an operation assistance method OSM for the electric work machine EWM of the embodiment with reference to Fig. 1B.

Fig. 1B is a flowchart illustrating an operation of the operation assistance device 1 illustrated in Fig. 1A, and is a flowchart describing each of steps in the operation assistance method OSM of the embodiment. The operation assistance method OSM of the embodiment is, for example, a method of using the operation assistance device 1 to allocate the plurality of electric work machines EWM1, EWM2, ..., EWMn to the respective plurality of work sites WS1, WS2, ..., WSn.

When the operation assistance method OSM illustrated in Fig. 1B is started, the operation assistance device 1 executes an information storing step S1 first. In Step S1, for example, the information storing section 11 stores information on workloads of the respective work sites WS. For example, the information on the workload is input to an input/output section of the operation assistance device 1 from an information terminal (not illustrated) owned by a user of the electric work machine EWM via the network N, and stored in the storage device of the operation assistance device 1 by the information storing section 11. An example of the information on the workload of the respective work sites WS stored by the information storing section 11 is illustrated in Table 1A below.

[Table 1A]

| Work Content | Scheduled Operation Completion Day | Working Days | Average Temperature during Operation (Daytime) | Average Temperature during Non-Operation (Nighttime) | Charge/Discharge Amount /Day | Discharge Power | Charge Power |
|---|---|---|---|---|---|---|---|
| 1 | - 8/30 | 60 days | 32°C | 24°C | 300 kWh | 60 kW | 100 kW |
| 2 | - 9/15 | 60 days | 28°C | 22°C | 180 kWh | 40 kW | 80 kW |
| 3 | - 10/3 | 60 days | 26°C | 20°C | 150 kWh | 50 kW | 50 kW |
| 4 | - 10/24 | 60 days | 24°C | 20°C | 200 kWh | 50 kW | 50 kW |

In the example illustrated in Table 1A, the information on the workload includes, for example, working days, an average temperature during operation (daytime) of the electric work machine EWM, an average temperature during non-operation (nighttime) of the electric work machine EWM, a charge/discharge amount per day, a discharge power, and a charge power. The information on the workload may include, for example, a discharge current and a charge current instead of the discharge power and the charge power. Next, the operation assistance device 1 executes a state acquiring step S2 of acquiring the degradation state SOH of the battery B mounted in each electric work machine EWM.

In Step S2, the state acquiring section 12 of the operation assistance device 1 acquires the degradation state SOH of the battery B mounted in each electric work machine EWM. The controller of each electric work machine EWM, for example, acquires the degradation state SOH of the battery B mounted in each electric work machine EWM at a predetermined interval, and transmits it to the operation assistance device 1 via the communication device, the wireless communication line RCL or the satellite communication line SCL, and the network N. The state acquiring section 12 acquires the degradation state SOH of the battery B of each of the electric work machines EWM transmitted from each of the electric work machines EWM via the input/output section of the operation assistance device 1.

Next, the operation assistance device 1 executes a work availability predicting step S3 of predicting an availability of work for each of the electric work machines EWM. In Step S3, the state predicting section 13 predicts, for example, the work availabilities of the respective electric work machines EWM at each of the work sites WS based on the information on the workload of the respective work sites WS stored by the information storing section 11.

More specifically, for example, the state predicting section 13 acquires specifications of the batteries B of the respective electric work machines EWM stored in the storage device by the information storing section 11, and performs comparison with the charge/discharge amount and the discharge power per day required at each of the work sites WS. Consequently, when the battery B of one electric work machine EWM cannot satisfy the charge/discharge amount and the discharge power per day required at one work site WS, it is recorded that the electric work machine EWM is not available at the work site WS.

Next, the operation assistance device 1 executes a state predicting step S4 of calculating a predicted degradation state ESOH of the battery B. In Step S4, the state predicting section 13 of the operation assistance device 1 calculates the predicted degradation state ESOH of the battery B when each of the electric work machines EWM works at each of the work sites WS. The predicted degradation state ESOH is a predicted value of the degradation state SOH of the battery B of each electric work machine EWM after each of the electric work machines EWM performs a predetermined work at each of the work sites WS.

For example, the state predicting section 13 predicts the predicted degradation state ESOH of the battery B of each electric work machine EWM with all or a part of the items of the workload as illustrated in Table 1A. More specifically, for example, the state predicting section 13 calculates the predicted degradation state ESOH using formulas (1) to (3) below.
[Math. 1]

$$a_{st} = a0 \cdot \exp\left(-\frac{a1}{T_{st}}\right) + a2 \cdot SOC_{st} + a3 \qquad \cdots (1)$$

[Math. 2]

$$a_{cyc} = a4 \cdot T_{op} + a5 \cdot \frac{D_{day}}{Q_{bat}} + a6 \cdot \frac{Dp}{Q_{bat}} + a7 \cdot \frac{Cp}{Q_{bat}} + a8 \qquad \cdots (2)$$

[Math. 3]

$$ESOH[\%] = 100 - a_{st} \times d^{0.5} - a_{cyc} \times d \qquad \cdots (3)$$

In the formula (1), a_st is a storage degradation rate [/d$^{0.5}$] (d: day) of the battery B. In the right side of the formula (1), T_st is an absolute storage temperature [K], SOC_st is a storage SOC ($0 \leq$ SOC_st < 1), a0 to a2 are coefficients, and a3 is a constant.

In the formula (2), a_cyc is a degradation speed [/d] of the battery B. In the right side of the formula (2), T_op is an average temperature [°C] during operation, D_day is a discharge power amount per day, Dp is a discharge power, and Cp is a charge power. Q_bat is a battery capacity of the battery B, a4 to a7 are coefficients, and a8 is a constant.

In the formula (3), ESOH is a predicted degradation state [%]. In the right side of the formula (3), a_st is the storage degradation rate [/d$^{0.5}$] of the battery B obtained with the formula (1), a_cyc is the degradation speed [/day] of the battery B obtained with the formula (2), and d is the number of operation days of the electric work machine EWM.

That is, the predicted degradation state ESOH is calculated based on the storage degradation rate a_st that is a degradation speed during storage or halt in which the battery B is not charged or discharged and the degradation speed a_cyc that is a speed of cycle degradation due to the charge and discharge of the battery B. The coefficients a0, al, a3 to a7 and the constants a3 and a8 in the formulas (1) and (2) are different for each battery B. Therefore, the coefficients and the constants of each battery B are, for example, stored in the storage device by the information storing section 11 of the operation assistance device 1 in advance.

Next, the operation assistance device 1 executes an operation plan generating step S5 of allocating the electric work machines EWM to the respective work sites WS. In Step S5, first, the operation planning section 14 of the operation assistance device 1 selects the work sites WS in the descending order of the workload based on the information on the workload of the respective work sites WS stored in the storage device (see Table 1A).

In Step S5, the operation planning section 14 further allocates a specific electric work machine EWM among the plurality of electric work machines EWM to the selected work site WS based on the predicted degradation state ESOH. With reference to Table 1B below, an exemplary procedure of allocating the electric work machines EWM to the respective work sites WS by the operation planning section 14.

[Table 1B]

| Machine No. | Battery Manufacturer | Battery Capacity [kWh] | SOH [%] | ESOH [%] (ΔSOH) High ← Workload → Low | | | |
|---|---|---|---|---|---|---|---|
| | | | | WS1 | WS2 | WS3 | WS4 |
| 1 | Company A | 200 | 90 | 82 (−8%) | 84 (−6%) | 85 (−5%) | 86 (−4%) |
| 2 | Company B | 300 | 86 | 81 (−5%) | 82 (−4%) | 83 (−3%) | 84 (−2%) |
| 3 | Company C | 150 | 86 | NA 76 (−10%) | 78 (−8%) | 80 (−6%) | 81 (−5%) |
| ⋮ | ⋮ | ⋮ | ⋮ | ⋮ | ⋮ | ⋮ | ⋮ |
| n | Company B | 200 | 85 | 78 (−7%) | 80 (−5%) | 81 (−4%) | 82 (−3%) |

In Table 1B, Machine No. is, for example, an identification number of each of the plurality of electric work machines EWM1, EWM2, ..., EWMn. Battery Manufacturer, Battery Capacity, and SOH are, for example, a manufacturer, a battery capacity, and a latest degradation state SOH of the battery B mounted in each electric work machine EWM.

ESOH is the predicted degradation state of the battery B after each of the electric work machines EWM performs the predetermined work at each of the work sites WS. The predicted degradation state ESOH is calculated for each of combinations of a plurality of work sites WS1, WS2, ..., WSn selected in the descending order of the workload from the left side to the right side and the plurality of electric work machines EWM1, EWM2, ..., EWMn.

ΔSOH is a battery degradation amount calculated based on the current degradation state SOH and the predicted degradation state ESOH of the battery B of each electric work machine EWM. Specifically, the battery degradation amount ΔSOH is a variation amount of the degradation state SOH from the current degradation state SOH of the battery B of each of the electric work machines EWM to the predicted degradation state ESOH when each of the electric work machines EWM works at each of the work sites WS.

That is, the operation planning section 14 calculates the battery degradation amount ΔSOH when each of the electric work machines EWM works at each of the work sites WS based on the degradation state SOH and the predicted degradation state ESOH of the battery B. Furthermore, for example, the operation planning section 14 selects the work site WS1 with the highest workload, and allocates the electric work machine EWM2 in which the battery degradation amount ΔSOH is -5 [%] and the reduction of the degradation state SOH is smallest among the plurality of electric work machines EWM1, EWM2, ..., EWMn to the work site WS1.

In the example illustrated in Table 1B, it is predicted that the electric work machine EWM3 of Machine No. 3 is non-available (NA) to the work at the work site WS1 in Step S3 of predicting the work availability of the electric work machine EWM. In this case, the operation planning section 14 does not allocate the electric work machine EWM3 to the work site WS1.

After the end of Step S5, for example, the operation planning section 14 executes Step S6 of determining whether or not the allocation of all the electric work machines EWM to the work sites WS has been completed. In Step S6, when it is determined that the allocation of at least one electric work machine EWM has not been completed (NO), the operation planning section 14 repeats Step S5 of allocating the electric work machines EWM to the respective work sites WS.

In Step S5 for the second time, the operation planning section 14 selects the work site WS2 with the second highest workload. The operation planning section 14 allocates the electric work machine EWMn in which the battery degradation amount ΔSOH is -5 [%] and the reduction of the degradation state SOH is smallest to the selected work site WS2 among the plurality of electric work machines EWM1, EWM3, ..., EWMn excluding the electric work machine EWM2 allocated to the work site WS1.

Similarly, the electric work machine EWM1 is allocated to the work site WS3 with the third highest workload in Step S5 for the third time, and the electric work machine EWM3 is allocated to the work site WS4 with the fourth highest workload in Step S5 for the fourth time. Then, when it is determined that the allocation of the electric work machines EWM to all the work sites WS has been completed (YES) in Step S6, the operation planning section 14 ends the operation assistance method OSM illustrated in Fig. 1B.

For example, the operation planning section 14 creates an operation plan of the electric work machines EWM including the information on the respective work sites WS allocated to the electric work machines EWM, and transmits the operation plan to the information terminal of the user of the electric work machine EWM via the network N. For example, the operation planning section 14 transmits the information on the respective work sites WS allocated to the electric work machines EWM to the respective electric work machines EWM via the network N and the satellite communication line SCL or the wireless communication line RCL.

The following describes actions of the operation assistance device 1 and the operation assistance method OSM for the electric work machine EWM of the embodiment.

The operation assistance device 1 of the embodiment is a device including a server that allocates a plurality of electric work machines EWM1, EWM2, ..., EWMn to a plurality of work sites WS1, WS2, ..., WSn. The server includes the information storing section 11, the state acquiring section 12, the state predicting section 13, and the operation planning section 14. The information storing section 11 stores information on the workload of the respective plurality of work sites WS1, WS2, ..., WSn. The state acquiring section 12 acquires the degradation state of the battery B mounted in each of the plurality of electric work machines EWM1, EWM2, ..., EWMn. The state predicting section 13 calculates the predicted degradation state ESOH of the battery B when each of the plurality of electric work machines EWM1, EWM2, ..., EWMn works at any of the plurality of work sites WS1, WS2, ..., WSn. The operation planning section 14 selects the work sites WS in the descending order of the workload based on the information on the workload stored in the information storing section 11, and allocates a specific electric work machine EWM among the plurality of electric work machines EWM1, EWM2, ..., EWMn to the work site WS in the selected order based on the degradation state of the battery B acquired by the state acquiring section 12 and the predicted degradation state ESOH of the battery B calculated by the state predicting section 13.

In other words, the operation assistance device 1 of the embodiment is, as described above, a server that allocates the plurality of electric work machines EWM1, EWM2, ..., EWMn to the respective plurality of work sites WS1, WS2, ..., WSn. The operation assistance device 1 includes the information storing section 11, the state acquiring section 12, the state predicting section 13, and the operation planning section 14. The information storing section 11 stores the information on the workload of the respective work sites WS. The state acquiring section 12 acquires the degradation state SOH of the battery B mounted in each electric work machine EWM. The state predicting section 13 calculates the predicted degradation state ESOH of the battery B when each of the electric work machines EWM works at each of the work sites WS. The operation planning section 14 selects the work sites WS in the descending order of the workload based on the information stored by the information storing section 11, and allocates a specific work site WS among the plurality of electric work machines EWM to the selected work site WS based on the predicted degradation state ESOH.

With this configuration, the operation assistance device 1 of the embodiment can sequentially allocate the appropriate electric work machines EWM among the plurality of electric work machines EWM1, EWM2, ..., EWMn to the plurality of work sites WS1, WS2, ..., WSn from the work site WS with the high workload to the work site WS with the low workload based on the predicted degradation state ESOH of the battery B. Accordingly, in each of the electric work machines EWM, the extreme reduction of the degradation state SOH of the battery B can be avoided, thus allowing suppressing the degradation and increasing the life of the battery B.

In the operation assistance device 1 of the embodiment, the operation planning section 14 calculates the battery degradation amount ΔSOH when each of the plurality of electric work machines EWM1, EWM2, ..., EWMn works at the plurality of work sites WS1, WS2, ..., WSn based on the degradation state SOH of the battery B and the predicted degradation state ESOH of the battery B. The operation planning section 14 selects the electric work machine EWM in which the battery degradation amount ΔSOH is smallest among the plurality of electric work machines EWM1, EWM2, ..., EWMn as a specific electric work machine WS.

In other words, in the operation assistance device 1 of the embodiment, for example, as illustrated in Table 1B, the operation planning section 14 calculates the battery degradation amount ΔSOH when each of the electric work machines EWM works at each of the work sites WS based on the degradation state SOH and the predicted degradation state ESOH of the battery B. Furthermore, the operation planning section 14 allocates the electric work machine EWM in which the battery degradation amount ΔSOH is smallest among the plurality of electric work machines EWM1, EWM2, ..., EWMn to the work site WS selected in the descending order of the workload.

With this configuration, the operation assistance device 1 of the embodiment can suppress the reduction of the degradation state SOH of the battery B after each of the electric work machines EWM works at each of the work sites WS to minimum. Consequently, the degradation of the plurality of batteries B mounted in the plurality of electric work machines EWM1, EWM2, ..., EWMn can be entirely suppressed, and the life of the batteries B can be entirely increased.

The operation assistance method OSM of the embodiment is a method for allocating the plurality of electric work machines EWM1, EWM2, ..., EWMn to the plurality of work sites WS1, WS2, ..., WSn. The operation assistance method OSM of the embodiment, as described above, includes the information storing step S1, the state acquiring step S2, the state predicting step S4, and the operation plan generating step S5. The information storing step S1 is a step of storing the information on the workload of the respective plurality of work sites WS1, WS2, ..., WSn. The state acquiring step S2 is a step of acquiring the degradation state SOH of the battery B mounted in each of the plurality of electric work machines EWM1, EWM2, ..., EWMn. The state predicting step S4 is a step of calculating the predicted degradation state ESOH of the battery B when each of the plurality of electric work machines EWM1, EWM2, ..., EWMn works at any of the plurality of work sites WS1, WS2, ..., WSn. The operation plan generating step S5 is a step of selecting the work sites WS in the descending order of the workload based on the information on the workload stored in the information storing step S1 and allocating a specific electric work machine EWM among the plurality of electric work machines EWM1, EWM2, ..., EWMn in the order of the selected work sites WS based on the degradation state SOH of the battery B acquired in the state acquiring step S2 and the predicted degradation state ESOH of the battery B calculated in the state predicting step S4.

In other words, the operation assistance method OSM of the embodiment is a method for allocating the plurality of electric work machines EWM1, EWM2, ..., EWMn to the respective plurality of work sites WS1, WS2, ..., WSn. As described above, the operation assistance method OSM of the embodiment includes the information storing step S1, the state acquiring step S2, the state predicting step S4, and the operation plan generating step S5. The information storing step S1 is a step of storing the information on the workload of the respective work sites WS. The state acquiring step S2 is a step of acquiring the degradation state SOH of the battery B mounted in each electric work machine EWM. The state predicting step S4 is a step of calculating the predicted degradation state ESOH of the battery B when each of the electric work machines EWM works at each of the work sites WS. The operation plan generating step S5 is a step of selecting the work sites WS in the descending order of the workload based on the information stored in the information storing step S1 and allocating a specific electric work machine EWM among the plurality of electric work machines EWM1, EWM2, ..., EWMn to the selected work site WS based on the predicted degradation state ESOH of the battery B.

With this configuration, according to the operation assistance method OSM of the embodiment, the appropriate electric work machines EWM among the plurality of the electric work machines EWM1, EWM2, ..., EWMn can be sequentially allocated to the plurality of work sites WS1, WS2, ..., WSn from the work site WS with the high workload to the work site WS with the low workload based on the predicted degradation state ESOH of the battery B. Accordingly, in each of the electric work machines EWM, the extreme reduction of the degradation state SOH of the battery B can be avoided, thus allowing suppressing the degradation and increasing the life of the battery B.

As described above, the embodiment can provide the operation assistance device 1 and the operation assistance method OSM for an electric work machine capable of suppressing the degradation and increasing the life of the battery B in the electric work machine EWM.

[Embodiment 2]

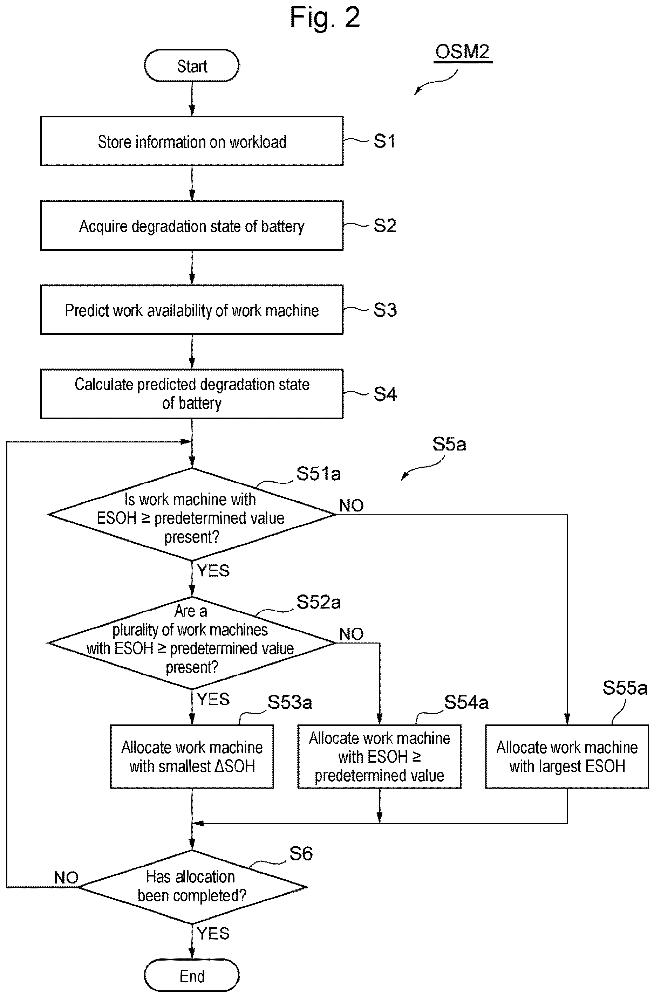

The following describes Embodiment 2 of the operation assistance device and the operation assistance method for an electric work machine according to the disclosure with reference to Fig. 1A, Fig. 2, and Table 2. Fig. 2 is a flowchart describing an operation of an operation assistance device 1 of the embodiment, and a flowchart describing each of steps in an operation assistance method OSM2 of the embodiment.

The operation assistance device 1 and the operation assistance method OSM2 of the embodiment are different from the operation assistance device 1 and the operation assistance method OSM of Embodiment 1 in an operation of an operation planning section 14 in an operation plan generating step S5a. The operation assistance device 1 and the operation assistance method OSM2 in the embodiment are otherwise similar to the operation assistance device 1 and the operation assistance method OSM in Embodiment 1, therefore, the same reference numerals are attached to the similar parts and the explanation is omitted.

When the operation assistance method OSM2 illustrated in Fig. 2 is started, the operation assistance device 1 of the embodiment executes from the information storing step S1 to the state predicting step S4 similarly to the above-described operation assistance method OSM. Thus, as illustrated in Table 2, the predicted degradation states ESOH and the battery degradation amounts ΔSOH when each of the plurality of electric work machines EWM1, EWM2, ..., EWMn works at each of the plurality of work sites WS1, WS2, ..., WSn are calculated.

[Table 2]

| Machine No. | Battery Manufacturer | Battery Capacity [kWh] | SOH [%] | ESOH [%] (ΔSOH) High ← Workload → Low | | | |
|---|---|---|---|---|---|---|---|
| | | | | WS1 | WS2 | WS3 | WS4 |
| 1 | Company A | 200 | 90 | 82 (−8%) | 84 (−6%) | 85 (−5%) | 86 (−4%) |
| 2 | Company B | 300 | 76 | 71 (−5%) | 72 (−4%) | 73 (−3%) | 74 (−2%) |
| 3 | Company C | 150 | 83 | NA 73 (−10%) | 75 (−8%) | 77 (−6%) | 78 (−5%) |
| 4 | Company B | 200 | 88 | 83 (−5%) | 84 (−4%) | 85 (−3%) | 86 (−2%) |
| ⋮ | ⋮ | ⋮ | ⋮ | ⋮ | ⋮ | ⋮ | ⋮ |
| n | Company B | 200 | 80 | 73 (−7%) | 75 (−5%) | 75 (−4%) | 77 (−3%) |

Then, the operation planning section 14 of the operation assistance device 1 executes the operation plan generating step S5a. In the operation assistance method OSM2 of the embodiment, for example, the operation plan generating step S5a includes Step S51a to Step S55a below. In Step S51a, the operation planning section 14 determines whether or not the electric work machine EWM in which the predicted degradation state ESOH of the battery B is equal to or more than a predetermined value is present when each of the plurality of electric work machines EWM1, EWM2, ..., EWMn works at the selected work site WS.

Here, the operation planning section 14 sets the predetermined value used for the determination in Step S51a to, for example, 80%. Then, in Step S51, the operation planning section 14 determines whether or not the electric work machine EWM in which the predicted degradation state ESOH is equal to or more than the predetermined value is present when each of the plurality of electric work machines EWM1, EWM2, ..., EWMn works at the work site WS1 selected at first as illustrated in Table 2.

At the work site WS1, the predicted degradation state ESOH of the battery B is equal to or more than 80% as the predetermined value in the electric work machines EWM1, EWM4 of Machine Nos. 1, 4. Accordingly, the operation planning section 14 determines that the electric work machine EWM in which the predicted degradation state ESOH is equal to or more than the predetermined value is present (YES) in Step S51a, and executes the next Step S52a.

In Step S52a, the operation planning section 14 determines whether or not a plurality of the electric work machines EWM in which the predicted degradation state ESOH is equal to or more than the predetermined value are present. At the work site WS1, the predicted degradation state ESOH of the battery B is equal to or more than 80% as the predetermined value in the electric work machines EWM1, EWM4 of Machine Nos. 1, 4. Accordingly, the operation planning section 14 determines that a plurality of the electric work machines EWM in which the predicted degradation state ESOH is equal to or more than the predetermined value are present (YES) in Step S52a, and executes the next Step S53a.

In Step S53a, the operation planning section 14 allocates a specific electric work machine EWM among the plurality of electric work machines EWM1, EWM2, ..., EWMn to the selected work site WS1 based on the predicted degradation state ESOH of the battery B when each of the electric work machines EWM works at the work site WS1. More specifically, for example, as illustrated in Table 2, the electric work machine EWM4 having the smallest battery degradation amount ΔSOH calculated based on the degradation state SOH and the predicted degradation state ESOH of the battery B of each electric work machine EWM is allocated to the work site WS1.

In Step S53a, similarly to Embodiment 1 described above, the operation planning section 14 excludes the work site WS3 determined to be non-available (NA) to the work at the work site WS1 in Step S3 from the plurality of the electric work machines EWM1, EWM2, ..., EWMn to be allocated to the work site WS1. Next, the operation planning section 14 executes Step S6 similarly to Embodiment 1, and when it is determined that the allocation of the electric work machines EWM to all the work sites WS has not been completed (NO), the operation planning section 14 repeats Step S51a and following steps described above.

In Step S51a for the second time, for example, the operation planning section 14 selects the work site WS2 with the second highest workload as illustrated in Table 2. Then, it is determined whether or not the electric work machine EWM in which the predicted degradation state ESOH in the case of working at the work site WS2 is equal to or more than the predetermined value is present in the plurality of electric work machines EWM1, EWM2, ..., EWMn excluding the electric work machine EWM4 already allocated to the other work site WS1.

Here, as illustrated in Table 2, for example, when the predetermined value is set to 80%, only the electric work machine EWM1 has the predicted degradation state ESOH equal to or more than the predetermined value in the case of working at the work site WS2 excluding the electric work machine EWM4. Therefore, the operation planning section 14 determines that the electric work machine EWM in which the predicted degradation state ESOH is equal to or more than the predetermined value is present (YES) in Step S51a for the second time, and further determines that the number of the electric work machines EWM in which the predicted degradation state ESOH is equal to or more than the predetermined value is not plural (NO) in Step S52a for the second time.

In this case, the operation planning section 14 executes Step S54a of allocating the electric work machine EWM1 in which the predicted degradation state ESOH is equal to or more than the predetermined value to the selected work site WS2, further executes Step S6 for the second time to determine that the allocation of the electric work machines EWM to all the work sites WS has not been completed (NO), and executes Step S51a for the third time. In Step S51a for the third time, the operation planning section 14 selects the work site WS3 with the third highest workload.

Here, as illustrated in Table 2, for example, when the predetermined value is set to 80%, the electric work machine EWM in which the predicted degradation state ESOH of the battery B after the work at the work site WS3 is equal to or more than the predetermined value is not present excluding the electric work machines EWM4, EWM1 already allocated to the other work sites WS1, WS2. Therefore, in Step S51a for the third time, the operation planning section 14 determines that the electric work machine EWM in which the predicted degradation state ESOH is equal to or more than the predetermined value is not present (NO), and execute the next Step S55a.

In Step S55a, the operation planning section 14 allocates the electric work machine EWM3 in which the predicted degradation state ESOH of the battery B is largest to the selected work site WS3 among the plurality of electric work machine EWM2, EWM3, ..., EWMn excluding the electric work machines EWM4, EWM1 allocated to the other work sites WS1, WS2. Subsequently, the operation planning section 14 performs Step S6 and Step S51a for the fourth time, and then executes Step S55a for the second time.

In Step S55a for the second time, the operation planning section 14 selects the work site WS4 with the fourth largest workload. The operation planning section 14 excludes the electric work machines EWM4, EWM1, EM3 allocated to the other work sites WS1, WS2, WS3 from candidates of the electric work machine EWM to be allocated to the selected work site WS4. Furthermore, the operation planning section 14 allocates the electric work machine EWMn in which the predicted degradation state ESOH of the battery B is largest among the plurality of electric work machines EWM2, ..., EWMn to the selected work site WS4.

Then, when the operation planning section 14 determines that the allocation of the electric work machines EWM to all the work sites WS has been completed (YES) in Step S6, the operation assistance device 1 ends the operation assistance method OSM2 illustrated in Fig. 2.

As described above, in the operation assistance device 1 of the embodiment, the operation planning section 14 determines whether or not the electric work machine EWM in which the predicted degradation state ESOH of the battery B is equal to or more than the predetermined value is present in the plurality of electric work machines EWM1, EWM2, ..., EWMn. Further, when the electric work machine EWM is present, the operation planning section 14 selects the electric work machine EWM4 in which the predicted degradation state ESOH of the battery B is equal to or more than the predetermined value and the battery degradation amount ΔSOH is smallest among the plurality of electric work machines EWM1, EWM2, ..., EWMn as a specific electric work machine EWM.

In other words, in the operation assistance device 1 of the embodiment, the operation planning section 14 determines whether or not a plurality of electric work machines EWM in which the predicted degradation state ESOH is equal to or more than the predetermined value are present in the plurality of electric work machines EWM1, EWM2, ..., EWMn. Further, when the plurality of electric work machines EWM are present, the operation planning section 14 allocates the electric work machine EWM4 in which the predicted degradation state ESOH of the battery B is equal to or more than the predetermined value and the battery degradation amount ΔSOH is smallest among the plurality of electric work machines EWM1, EWM2, ..., EWMn to the selected work site WS1.

With this configuration, the operation assistance device 1 of the embodiment can allocate the electric work machine EWM4 in which the predicted degradation state ESOH of the battery B is equal to or more than the predetermined value and the battery degradation amount ΔSOH is smallest to the work site WS1 with the higher workload than the other work sites WS2, WS3, ..., Wsn. Accordingly, the operation assistance device 1 of the embodiment allows suppressing the degradation and increasing the life of the battery B of each of the plurality of electric work machines EWM1, EWM2, ..., EWMn compared with a case where the electric work machines EWM1, EWM2, ..., EWMn provided with the batteries B with the relatively low predicted degradation state ESOH and the relatively large battery degradation amount ΔSOH are allocated to the work site WS1 with the relatively high workload.

In the operation assistance device 1 of the embodiment, when it is determined that only one electric work machine EWM1 in which the predicted degradation state ESOH is equal to or more than the predetermined value is present in the plurality of electric work machines EWM1, EWM2, ..., EWMn, the operation planning section 14 allocates the electric work machine EWM1 in which the predicted degradation state ESOH is equal to or more than the predetermined value to the selected work site WS2.

With this configuration, the operation assistance device 1 of the embodiment can allocate the electric work machine EWM1 in which the predicted degradation state ESOH of the battery B is equal to or more than the predetermined value to the work site WS2 with the higher workload than the other work sites WS3, WS4. Accordingly, the operation assistance device 1 of the embodiment allows suppressing the degradation and increasing the life of the battery B of each of the plurality of electric work machines EWM2, EWM3, ..., EWMn compared with a case where the electric work machines EWM2, EWM3, ..., EWMn provided with the batteries B with the relatively low predicted degradation state ESOH are allocated to the work site WS2 with the relatively high workload.

In the operation assistance device 1 of the embodiment, when the electric work machine EWM in which the predicted degradation state ESOH of the battery B is equal to or more than the predetermined value is not present in the plurality of electric work machines EWM2, EWM3, ..., EWMn, the operation planning section 14 selects the electric work machine EWM in which the predicted degradation state ESOH of the battery B is largest among the plurality of electric work machines EWM2, EWM3, ..., EWMn as the specific electric work machine EWM.

In other words, in the operation assistance device 1 of the embodiment, the operation planning section 14 allocates the electric work machine EWM3 in which the predicted degradation state ESOH is largest among the plurality of electric work machines EWM2, EWM3, ..., EWMn to the selected work site WS3. Similarly, the operation planning section 14 allocates the electric work machine EWMn in which the predicted degradation state ESOH is largest among the plurality of electric work machines EWM2, ..., EWMn to the selected work site WS4.

With this configuration, the operation assistance device 1 of the embodiment can allocate the electric work machine EWM3 in which the predicted degradation state ESOH of the battery B is largest to the work site WS3 with the higher workload than the other work site WS4. Similarly, the electric work machine EWMn in which the predicted degradation state ESOH of the battery B is largest can be allocated to the work site WS4 with the higher workload than the other work site WS. Accordingly, the operation assistance device 1 of the embodiment allows suppressing the degradation and increasing the life of the battery B of each of the plurality of electric work machines EWM2, EWM3, ..., EWMn.

As described above, similarly to Embodiment 1 described above, the embodiment can provide the operation assistance device 1 and the operation assistance method OSM2 for an electric work machine capable of suppressing the degradation and increasing the life of the battery B in the electric work machine EWM.

[Embodiment 3]

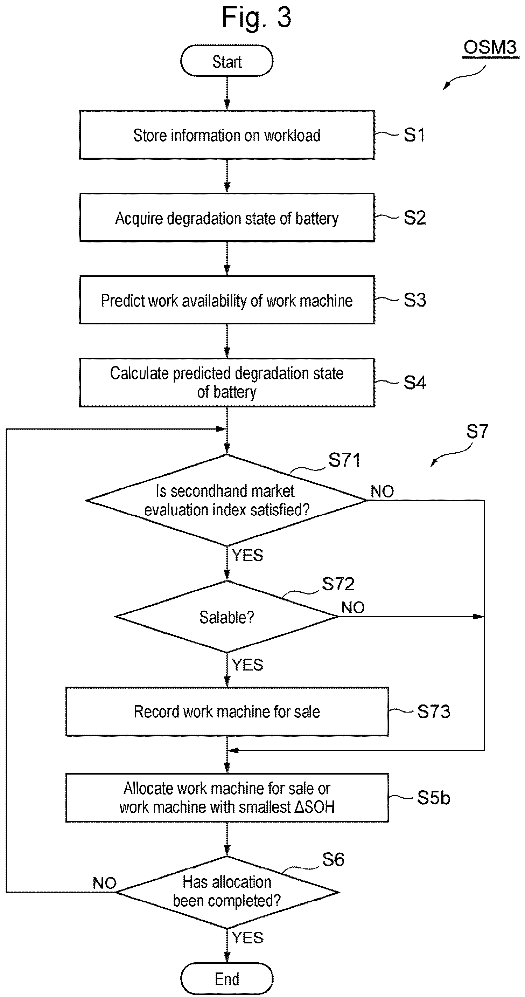

The following describes Embodiment 3 of the operation assistance device and the operation assistance method for an electric work machine according to the disclosure with reference to Fig. 1A, Fig. 3, Table 3A, and Table 3B. Fig. 3 is a flowchart describing an operation of an operation assistance device 1 of the embodiment, and a flowchart describing each of steps in an operation assistance method OSM3 of the embodiment.

The operation assistance device 1 and the operation assistance method OSM3 of the embodiment are different from the operation assistance device 1 and the operation assistance method OSM of Embodiment 1 in that an operation planning section 14 executes a disposal assessment step S7, and different in an operation of the operation planning section 14 in an operation plan generating step S5b following Step S7. The operation assistance device 1 and the operation assistance method OSM3 in the embodiment are otherwise similar to the operation assistance device 1 and the operation assistance method OSM in Embodiment 1, therefore, the same reference numerals are attached to the similar parts and the explanation is omitted.

When the operation assistance method OSM3 illustrated in Fig. 3 is started, the operation assistance device 1 of the embodiment executes from Step S1 to Step S4 similarly to Embodiment 1 described above. Then, the operation assistance device 1 executes the disposal assessment step S7. Step S7 includes, for example, Step S71 to Step S73 below. In Step S71, the operation planning section 14 of the operation assistance device 1 determines whether or not each of the plurality of electric work machines EWM1, EWM2, ..., EWMn satisfies an evaluation index of a secondhand market.

More specifically, the operation planning section 14 acquires, for example, the degradation state SOH, a period of use, and a total operating time of the battery B of each of the electric work machines EWM stored in the storage device by the information storing section 11 as illustrated in Table 3A below. Further, the operation planning section 14 acquires, for example, a secondhand market evaluation index of each of the plurality of electric work machines EWM1, EWM2, ..., EWMn stored in the storage device by the information storing section 11 as illustrated in Table 3B below.

[Table 3A]

| Machine No. | Battery Manufacturer | Battery Capacity [kWh] | SOH [%] | Period of Use [year] | Total Operating Time [h] | ESOH [%] (ΔSOH) High ← Workload → Low | | | |
|---|---|---|---|---|---|---|---|---|---|
| | | | | | | WS1 | WS2 | WS3 | WS4 |
| 1 | Company A | 200 | 90 | 2 | 1900 | 82 (−8%) | 84 (−6%) | 85 (−5%) | 86 (−4%) |
| 2 | Company B | 300 | 86 | 4 | 7000 | 81 (−5%) | 82 (−4%) | 83 (−3%) | 84 (−2%) |
| 3 | Company C | 150 | 86 | 3 | 4500 | NA 76 (−10%) | 78 (−8%) | 80 (−6%) | 81 (−5%) |
| 4 | Company B | 200 | 88 | 2 | 2500 | 82 (−6%) | 84 (−4%) | 85 (−3%) | 86 (−2%) |
| ⋮ | ⋮ | ⋮ | ⋮ | ⋮ | ⋮ | ⋮ | ⋮ | ⋮ | ⋮ |
| n | Company B | 200 | 85 | 5 | 8200 | 78 (−7%) | 80 (−5%) | 81 (−4%) | 82 (−3%) |

[Table 3B]

| Machine No. | Secondhand Market Evaluation Index | | |
|---|---|---|---|
| | Period of Use [year] | Total Operating Time [h] | SOH [%] |
| 1 | ≤ 5 | ≤ 8000 | ≥ 80 |
| 2 | ≤ 5 | ≤ 8000 | ≥ 75 |
| 3 | ≤ 3 | ≤ 5000 | ≥ 80 |
| 4 | ≤ 5 | ≤ 8000 | ≥ 80 |
| ⋮ | ⋮ | ⋮ | ⋮ |
| n | ≤ 3 | ≤ 5000 | ≥ 80 |

The secondhand market evaluation index of each of the electric work machines EWM includes conditions of, for example, as illustrated in Table 3B, the period of use, the total operating time, and the degradation state SOH of the battery B set for each of the plurality of electric work machines EWM1, EWM2, ..., EWMn. These conditions can be set to any conditions, for example, under which each of the electric work machines EWM can be sold at a high price equal to or more than a predetermined price in the secondhand market.

Since the degradation state SOH, the period of use, the total operating time, and the secondhand market evaluation index of each of the electric work machines EWM vary over time, for example, they can be periodically updated. For example, when the battery manufacturer, the battery capacity, and the like are changed because of the replacement and the like of the battery B, these kinds of information are updated as well.

In Step S71, for example, the operation planning section 14 excludes the electric work machine EWM3 determined to be non-available (NA) to the work site WS1 in Step S3 from a determination target. Further, in Step S71, for example, the operation planning section 14 compares the degradation state SOH, the period of use, and the total operating time of the battery B of each of the plurality of electric work machines EWM1, EWM2, ..., EWMn illustrated in Table 3A with the conditions of each of the electric work machines EWM illustrated in Table 3B.

In the example illustrated in Table 3A, the degradation state SOH, the period of use, and the total operating time of the battery B of the electric work machines EWM1, EWM2, EWM4 of the machine Nos. 1, 2, 4, excluding the electric work machine EWM3, enclosed in a bold frame satisfy the secondhand market evaluation index of each of the electric work machines EWM1, EWM2, EWM4 enclosed in a bold frame in Table 3B. In this case, the operation planning section 14 determines that the electric work machines EWM1, EWM2, EWM4 satisfy the evaluation index of the secondhand market (YES) in Step S71.

In Step S71, the operation planning section 14 determines that the electric work machines EWM3, EWMn do not satisfy the evaluation index of the secondhand market (NO). Then, the operation planning section 14 executes Step S72 of determining a salability of the electric work machines EWM1, EWM2, EWM4 that satisfy the evaluation index of the secondhand market.

More specifically, in Step S72, for example, the operation planning section 14 transmits a query about the salability of the electric work machines EWM1, EWM2, EWM4 to a terminal of a user, and accepts the input of the salability from the terminal of the user. In Step S72, for example, the operation planning section 14 determines the salability of the electric work machines EWM1, EWM2, EWM4 based on the input salability. Here, in Step S72, when the operation planning section 14 determines that the electric work machines EWM1, EWM2, EWM4 are not salable (NO), Step S5b for the first time is executed.

In Step S5b for the first time, the operation planning section 14 selects the work site WS1 with the highest workload similarly to Embodiment 1. Furthermore, as illustrated in Table 3A, the operation planning section 14 allocates the electric work machine EWM2 with the smallest battery degradation amount ∆SOH of the battery B in the case of the work at the selected work site WS1 to the selected work site WS1. Subsequently, the operation planning section 14 performs Step S6, and then executes Step S71 for the second time.

In Step S71 for the second time, the operation planning section 14 determines that the electric work machines EWM1, EWM4 satisfy the evaluation index of the secondhand market (YES), and executes Step S72 for the second time. When the operation planning section 14 determines that the electric work machines EWM1, EWM4 are not salable (NO) in Step S72 for the second time, Step S5b for the second time is executed. In Step S5b for the second time, the operation planning section 14 allocates the electric work machine EWM4 in which the battery degradation amount ∆SOH is smallest among the remaining plurality of electric work machines EWM1, EWM3, EWM4, EWMn to the work site WS2 with the second highest workload.

Subsequently, the operation planning section 14 performs Step S6, and then executes Step S71 for the third time. In Step S71 for the third time, the operation planning section 14 determines that the electric work machines EWM1, EWM3 satisfy the evaluation index of the secondhand market (YES), and executes Step S72 for the third time. In Step S72 for the third time, for example, when the operation planning section 14 determines that the electric work machine EWM1 is not salable (NO) and the electric work machine EWM3 is salable (YES), the next Step S73 is executed.

In Step S73, for example, the operation planning section 14 records information on the electric work machine EWM3 for sale in the storage device via the information storing section 11. Then, Step S5b for the third time is executed. In Step S5b for the third time, the operation planning section 14 allocates, for example, the electric work machine EWM3 for sale determined to be salable (YES) in the preceding Step S72 to the work site WS3 with the third highest workload. The electric work machine EWM3 for sale is, for example, sold in the secondhand market after the end of the work at the work site WS3. Subsequently, the operation planning section 14 performs Step S6, and then executes Step S71 for the fourth time.

In Step S71 for the fourth time, the operation planning section 14 determines that the electric work machine EWM1 satisfies the evaluation index of the secondhand market (YES), and executes Step S72 for the fourth time. In Step S72 for the fourth time, for example, when the operation planning section 14 determines that the electric work machine EWM1 is not salable (NO), Step S5b for the fourth time is executed. In Step S5b for the fourth time, the operation planning section 14 allocates, for example, the electric work machine EWMn in which the battery degradation amount ∆SOH is smallest among the remaining plurality of electric work machines EWM1, EWMn to the work site WS4 with the fourth highest workload.

As described above, in the operation assistance device 1 of the embodiment, the operation planning section 14 records the electric work machine EWM4 that satisfies a predetermined secondhand market evaluation index and is determined to be salable by the user among the plurality of electric work machines EWM1, EWM2, ..., EWMn as an electric work machine for sale. With this configuration, the operation assistance device 1 and the operation assistance method OSM3 of the embodiment can not only provide the effects similar to those of the operation assistance device 1 and the operation assistance method OSM of Embodiment 1, but also select the highly valued electric work machine EWM and sell it at high price in the secondhand market.

[Embodiment 4]

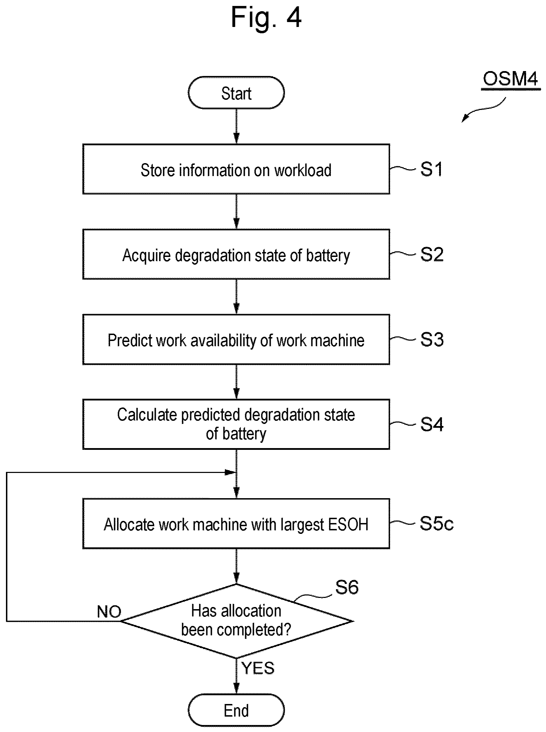

The following describes Embodiment 4 of the operation assistance device and the operation assistance method for an electric work machine according to the disclosure with reference to Fig. 1A, Fig. 4, and Table 4. Fig. 4 is a flowchart describing an operation of an operation assistance device 1 of the embodiment, and a flowchart describing each of steps in an operation assistance method OSM4 of the embodiment.

The operation assistance device 1 and the operation assistance method OSM4 of the embodiment are different from the operation assistance device 1 and the operation assistance method OSM of Embodiment 1 in an operation of an operation planning section 14 in an operation plan generating step S5c. The operation assistance device 1 and the operation assistance method OSM4 in the embodiment are otherwise similar to the operation assistance device 1 and the operation assistance method OSM in Embodiment 1, therefore, the same reference numerals are attached to the similar parts and the explanation is omitted.

When the operation assistance method OSM4 illustrated in Fig. 4 is started, the operation assistance device 1 of the embodiment executes from Step S1 to Step S4 similarly to Embodiment 1 described above. Then, the operation assistance device 1 executes the operation plan generating step S5c. In Step S5c, the operation planning section 14 of the operation assistance device 1 selects the work sites WS in the descending order of the workload based on the information stored by the information storing section 11 similarly to Embodiment 1.

Furthermore, the operation planning section 14 allocates the specific electric work machine EWM among the plurality of electric work machines EWM to the selected work site WS based on the predicted degradation state ESOH similarly to Embodiment 1. Here, for example, as illustrated in Table 4 below, the operation planning section 14 allocates the electric work machine EWM in which the predicted degradation state ESOH is largest among the plurality of electric work machines EWM to the selected work site WS.

[Table 4]

| Machine No. | Battery Manufacturer | Battery Capacity [kWh] | SOH [%] | ESOH [%] ($\Delta$SOH) High ← Workload → Low | | | |
|---|---|---|---|---|---|---|---|
| | | | | WS1 | WS2 | WS3 | WS4 |
| 1 | Company A | 200 | 90 | 82 (−8%) | 84 (−6%) | 85 (−5%) | 86 (−4%) |
| 2 | Company B | 300 | 86 | 81 (−5%) | 82 (−4%) | 83 (−3%) | 84 (−2%) |
| 3 | Company C | 150 | 86 | NA 76 (−10%) | 78 (−8%) | 80 (−6%) | 81 (−5%) |
| ⋮ | ⋮ | ⋮ | ⋮ | ⋮ | ⋮ | ⋮ | ⋮ |
| n | Company B | 200 | 85 | 78 (−7%) | 80 (−5%) | 81 (−4%) | 82 (−3%) |

As illustrated in Table 4, to the work site WS1 with the highest workload, the electric work machine EWM1 in which the predicted degradation state ESOH is largest among the plurality of electric work machines EWM1, EWM2, ..., EWMn excluding the electric work machine EWM3 excluded because of not being available (NA) is allocated. Similarly, the electric work machine EWM2 is allocated to the work site WS2, the electric work machine EWMn is allocated to the work site WS3, and the electric work machine EWM3 is allocated to the work site WS4.

According to the operation assistance device 1 and the operation assistance method OSM4 of the embodiment, the electric work machines EWM in which the predicted degradation state ESOH of the battery B after the work is largest can be sequentially allocated to the work sites WS from the work site WS with the high workload to the work site WS with the low workload. Accordingly, similarly to Embodiment 1 described above, the embodiment can provide the operation assistance device 1 and the operation assistance method OSM4 for an electric work machine capable of suppressing the degradation and increasing the life of the battery B in the electric work machine EWM.

[Embodiment 5]

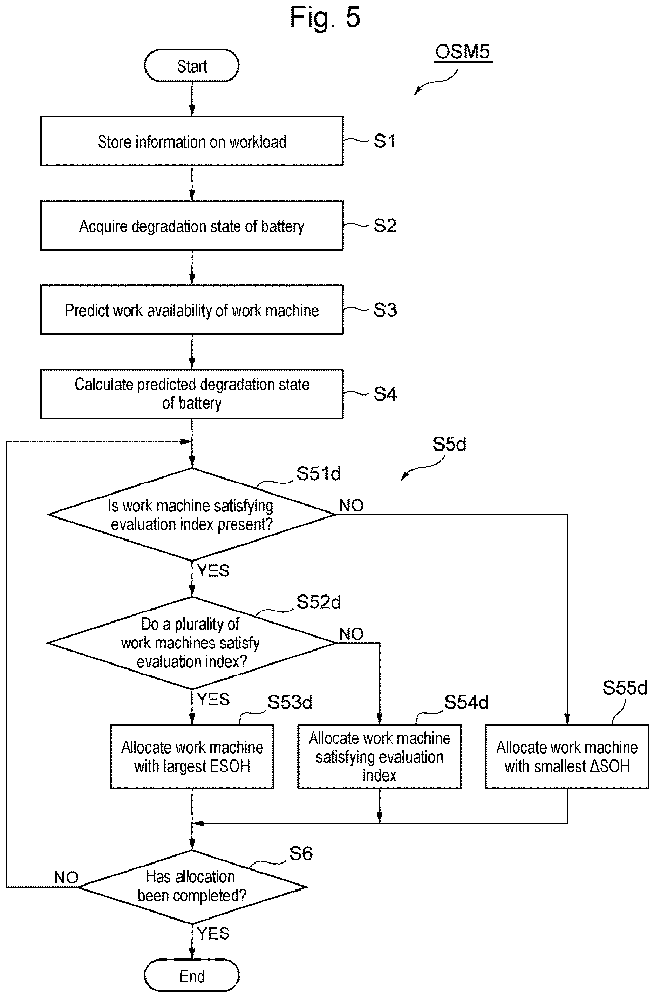

The following describes Embodiment 5 of the operation assistance device and the operation assistance method for an electric work machine according to the disclosure with reference to Fig. 1A, Fig. 5, Table 5A, and Table 5B. Fig. 5 is a flowchart describing an operation of an operation assistance device 1 of the embodiment, and a flowchart describing each of steps in an operation assistance method OSM5 of the embodiment.

The operation assistance device 1 and the operation assistance method OSM5 of the embodiment are different from the operation assistance device 1 and the operation assistance method OSM of Embodiment 1 in an operation of an operation planning section 14 in an operation plan generating step S5d. The operation assistance device 1 and the operation assistance method OSM5 in the embodiment are otherwise similar to the operation assistance device 1 and the operation assistance method OSM in Embodiment 1, therefore, the same reference numerals are attached to the similar parts and the explanation is omitted.

When the operation assistance method OSM5 illustrated in Fig. 5 is started, the operation assistance device 1 of the embodiment executes from Step S1 to Step S4 similarly to Embodiment 1 described above. Then, the operation assistance device 1 executes the operation plan generating step S5d. In the operation assistance method OSM5 of the embodiment, the operation plan generating step S5d includes, for example, Step S51d to Step S55d below. The following describes the operation plan generating step S5d by the operation assistance device 1 of the embodiment with reference to Table 5A and Table 5B.

[Table 5A]

| Machine No. | Battery Manufacturer | Battery Capacity [kWh] | SOH [%] | Period of Use [year] | Total Operating Time [h] | ESOH [%] ($\Delta$SOH) High ← Workload → Low | | | |
|---|---|---|---|---|---|---|---|---|---|
| | | | | | | WS1 | WS2 | WS3 | WS4 |
| 1 | Company A | 200 | 90 | 2 | 1900 | 82 (−8%) | 84 (−6%) | 85 (−5%) | 86 (−4%) |
| 2 | Company B | 300 | 86 | 4 | 7000 | 81 (−5%) | 82 (−4%) | 83 (−3%) | 84 (−2%) |
| 3 | Company C | 150 | 86 | 3 | 4500 | NA 76 (−10%) | 78 (−8%) | 80 (−6%) | 81 (−5%) |
| 4 | Company B | 200 | 85 | 2 | 2500 | 79 (−6%) | 81 (−4%) | 82 (−3%) | 83 (−2%) |
| ⋮ | ⋮ | ⋮ | ⋮ | ⋮ | ⋮ | ⋮ | ⋮ | ⋮ | ⋮ |
| n | Company B | 200 | 85 | 5 | 8200 | 78 (−7%) | 80 (−5%) | 81 (−4%) | 82 (−3%) |

[Table 5B]

| Machine No. | Secondhand Market Evaluation Index | | |
|---|---|---|---|
| | Period of Use [year] | Total Operating Time [h] | SOH [%] |
| 1 | ≤ 5 | ≤ 8000 | 80 - 82 |
| 2 | ≤ 5 | ≤ 8000 | 75 - 77 |
| 3 | ≤ 3 | ≤ 5000 | 80 - 82 |
| 4 | ≤ 5 | ≤ 8000 | 80 - 82 |
| ⋮ | ⋮ | ⋮ | ⋮ |
| n | ≤ 3 | ≤ 5000 | 80 - 82 |

In Step S51d, the operation planning section 14 selects the work site WS1 with the highest workload, and then determines whether or not the electric work machine EWM satisfying a predetermined evaluation index is present. Here, the evaluation index of the electric work machine EWM includes, for example, as illustrated in Table 5B, the conditions of the period of use, the total operating time, and the degradation state SOH set for each of the electric work machines EWM.

Here, the predicted degradation state ESOH of the battery B of each electric work machine EWM in the case of the work at the work site WS1 illustrated in Table 5A is referred to. The predicted degradation state ESOH of the electric work machine EWM1 satisfies the condition of the degradation state SOH and also satisfies the conditions of the period of use and the total operating time illustrated in Table 5B. The predicted degradation state ESOH of the battery B of the other electric work machines EWM does not satisfy the degradation state SOH as the evaluation index of the respective electric work machines EWM.

In this case, the operation planning section 14 determines that the electric work machine EWM satisfying the evaluation index is present (YES) in Step S51d, and determines that a plurality of electric work machines EWM do not satisfy the evaluation index (NO) in the next Step S52d. Furthermore, the operation planning section 14 executes Step S54d, and allocates the electric work machine EWM1 satisfying the evaluation index to the selected work site WS1. Subsequently, the operation planning section 14 performs Step S6, and then executes Step S51d for the second time.

In Step S51d for the second time, the operation planning section 14 selects the work site WS2 with the second highest workload. Furthermore, the operation planning section 14 determines whether or not the electric work machine EWM in which the period of use, the total operating time, and the predicted degradation state ESOH of the battery B in the case of the work at the selected work site WS2 satisfy the evaluation indexes is present. At the work site WS2, only the electric work machine EWM4 of Machine No. 4 satisfies the evaluation indexes.

In this case, the operation planning section 14 determines that the electric work machine EWM satisfying the evaluation index is present (YES) in Step S51d for the second time, and determines that a plurality of electric work machines EWM do not satisfy the evaluation index (NO) in Step S52d for the second time. Furthermore, the operation planning section 14 executes Step S54d for the second time, and allocates the electric work machine EWM4 satisfying the evaluation index to the selected work site WS2. Subsequently, the operation planning section 14 performs Step S6, and then executes Step S51d for the third time.

In Step S51d for the third time, the operation planning section 14 selects the work site WS3 with the third highest workload. Furthermore, the operation planning section 14 determines whether or not the electric work machine EWM in which the period of use, the total operating time, and the predicted degradation state ESOH of the battery B in the case of the work at the selected work site WS3 satisfy the evaluation indexes is present. At the work site WS3, only the electric work machine EWM3 of Machine No. 3 satisfies the evaluation indexes.

In this case, the operation planning section 14 determines that the electric work machine EWM satisfying the evaluation index is present (YES) in Step S51d for the third time, and determines that a plurality of electric work machines EWM do not satisfy the evaluation index (NO) in Step S52d for the third time. Furthermore, the operation planning section 14 executes Step S54d for the third time, and allocates the electric work machine EWM3 satisfying the evaluation index to the selected work site WS3. Subsequently, the operation planning section 14 performs Step S6, and then executes Step S51d for the fourth time.

In Step S51d for the fourth time, the operation planning section 14 selects the work site WS4 with the fourth highest workload. Furthermore, the operation planning section 14 determines whether or not the electric work machine EWM in which the period of use, the total operating time, and the predicted degradation state ESOH of the battery B in the case of the work at the selected work site WS4 satisfy the evaluation indexes is present. At the work site WS4, the two electric work machines EWM2, EWMn of Machine Nos. 2, n satisfy the evaluation indexes.

In this case, the operation planning section 14 determines that the electric work machine EWM satisfying the evaluation index is present (YES) in Step S51d for the fourth time, and determines that a plurality of electric work machines EWM satisfy the evaluation index (YES) in Step S52d for the fourth time. Furthermore, the operation planning section 14 executes the next Step S53d and allocates the electric work machine EWM2 in which the predicted degradation state ESOH is largest among the plurality of electric work machines EWM2, EWMn satisfying the evaluation index to the selected work site WS4.

Meanwhile, when it is determined that the work machine satisfying the evaluation index is not present (NO) in Step S51d, the operation planning section 14 executes Step S55d of allocating the electric work machine EWM in which the battery degradation amount $\Delta$SOH is smallest to the selected work site WS. Then, when the operation planning section 14 determines that the allocation of the electric work machines EWM to all the work sites WS has been completed in Step S6, the operation assistance device 1 ends the operation assistance method OSM5 illustrated in Fig. 5.

As described above, in the operation assistance device 1 of the embodiment, when the electric work machine EWM satisfying the predetermined evaluation index is present in the plurality of electric work machines EWM, the operation planning section 14 selects the electric work machine EWM that satisfies the evaluation index and has the largest predicted degradation state ESOH of the battery B among the plurality of electric work machines EWM as the specific electric work machine EWM.

In other words, in the operation assistance device 1 of the embodiment, when a plurality of electric work machines EWM satisfying the predetermined evaluation index is present in the plurality of operation assistance device 1, the operation planning section 14 allocates the electric work machine EWM that satisfies the evaluation index and has the largest predicted degradation state ESOH among the plurality of electric work machines EWM to the selected work site WS. With this configuration, the operation assistance device 1 and the operation assistance method OSM5 of the embodiment can not only provide the effects similar to those of Embodiment 1, but also appropriately manage the specifications of the electric work machines EWM allocated to the respective work sites WS.

While the embodiments of the operation assistance device and the operation assistance method for the electric work machine according to the disclosure are described above in detail with reference to the drawings, the specific configurations are not limited to the embodiments, and design changes and the like within a scope not departing from the gist of the disclosure are included in the disclosure.

Reference Signs List

| | |
|---|---|
| 1 | Server (operation assistance device) |
| 11 | Information storing section |

| 12 | State acquiring section |
| 13 | State predicting section |
| 14 | Operation planning section |
| B | Battery |
| ESOH | Predicted degradation state |
| EWM, EWM1 to EWMn | Electric work machine |
| OSM, OSM2 to OSM5 | Operation assistance method |
| S1 | Information storing step |
| S2 | State acquiring step |
| S4 | State predicting step |
| S5, S5a to S5d | Operation plan generating step |
| SOH | Degradation state |
| WS, WS1 to WSn | Work site |
| ΔSOH | Battery degradation amount |

**Claims**

1. An operation assistance device for an electric work machine comprising

   a server that allocates a plurality of electric work machines to a plurality of work sites,
   wherein the server includes:

   an information storing section that stores each piece of information on a workload of the plurality of work sites;
   a state acquiring section that acquires a degradation state of a battery mounted in each of the plurality of electric work machines;
   a state predicting section that calculates a predicted degradation state of the battery when each of the plurality of electric work machines works at any of the plurality of work sites; and
   an operation planning section that selects the work sites in a descending order of the workload based on the information on the workload stored in the information storing section, and allocates a specific electric work machine among the plurality of electric work machines to the work site in the selected order based on the degradation state of the battery acquired by the state acquiring section and the predicted degradation state of the battery calculated by the state predicting section.

2. The operation assistance device for an electric work machine according to claim 1,
   wherein the operation planning section calculates a battery degradation amount when each of the plurality of electric work machines works at the plurality of work sites based on the degradation state of the battery and the predicted degradation state of the battery, and selects the electric work machine in which the battery degradation amount is smallest among the plurality of electric work machines as the specific electric work machine.

3. The operation assistance device for an electric work machine according to claim 2,
   wherein when an electric work machine in which the predicted degradation state of the battery is equal to or more than a predetermined value is present in the plurality of electric work machines, the operation planning section selects an electric work machine in which the predicted degradation state of the battery is equal to or more than the predetermined value and the battery degradation amount is smallest among the plurality of electric work machines as the specific electric work machine.

4. The operation assistance device for an electric work machine according to claim 2,
   wherein when any electric work machine in which the predicted degradation state of the battery is equal to or more than a predetermined value is not present in the plurality of electric work machines, the operation planning section selects an electric work machine in which the predicted degradation state of the battery is largest among the plurality of electric work machines as the specific electric work machine.

5. The operation assistance device for an electric work machine according to claim 3,
   wherein when any electric work machine in which the predicted degradation state of the battery is equal to or more than a predetermined value is not present in the plurality of electric work machines, the operation planning section selects an electric work machine in which the predicted degradation state of the battery is largest among the plurality of electric work machines as the specific electric work machine.

6. The operation assistance device for an electric work machine according to claim 1,
wherein when an electric work machine that satisfies a predetermined evaluation index is present in the plurality of electric work machines, the operation planning section selects an electric work machine that satisfies the evaluation index and has a largest predicted degradation state of the battery among the plurality of electric work machines as the specific electric work machine.

7. The operation assistance device for an electric work machine according to claim 1,
wherein the operation planning section records an electric work machine that satisfies a predetermined secondhand market evaluation index and is determined to be salable by a user among the plurality of electric work machines as an electric work machine for sale.

8. An operation assistance method for allocating a plurality of electric work machines to a plurality of work sites, comprising:

an information storing step of storing each piece of information on a workload of the plurality of work sites;
a state acquiring step of acquiring a degradation state of a battery mounted in each of the plurality of electric work machines;
a state predicting step of calculating a predicted degradation state of the battery when each of the plurality of electric work machines works at any of the plurality of work sites; and
an operation plan generating step of selecting the work sites in a descending order of the workload based on the information on the workload stored in the information storing step, and allocating a specific electric work machine among the plurality of electric work machines to the work sites in the selected order based on the degradation state of the battery acquired by the state acquiring step and the predicted degradation state of the battery calculated by the state predicting step.

Fig. 1A

# Fig. 1B

```
                                    OSM
          ┌──────────┐
          │  Start   │
          └────┬─────┘
               │
   ┌───────────────────────────────┐
   │  Store information on workload │ ── S1
   └───────────────┬───────────────┘
                   │
   ┌───────────────────────────────┐
   │ Acquire degradation state of  │ ── S2
   │           battery             │
   └───────────────┬───────────────┘
                   │
   ┌───────────────────────────────┐
   │ Predict work availability of  │ ── S3
   │         work machine          │
   └───────────────┬───────────────┘
                   │
   ┌───────────────────────────────┐
   │ Calculate predicted           │ ── S4
   │ degradation state of battery  │
   └───────────────┬───────────────┘
                   │
   ┌───────────────────────────────┐
   │ Allocate work machine to      │ ── S5
   │         work site             │
   └───────────────┬───────────────┘
                   │
            ╱───────────╲   S6
    NO     ╱ Has allocation ╲
   ◄──────◄  been completed?  ►
            ╲               ╱
             ╲─────┬───────╱
                   │ YES
          ┌────────────────┐
          │      End       │
          └────────────────┘
```

## Fig. 2

OSM2

```
                        ┌─────────┐
                        │  Start  │
                        └─────────┘
                             │
                             ▼
        ┌──────────────────────────────────────┐
        │    Store information on workload      │──── S1
        └──────────────────────────────────────┘
                             │
                             ▼
        ┌──────────────────────────────────────┐
        │   Acquire degradation state of battery│──── S2
        └──────────────────────────────────────┘
                             │
                             ▼
        ┌──────────────────────────────────────┐
        │  Predict work availability of work    │──── S3
        │              machine                  │
        └──────────────────────────────────────┘
                             │
                             ▼
        ┌──────────────────────────────────────┐
        │  Calculate predicted degradation state│──── S4
        │            of battery                 │
        └──────────────────────────────────────┘
```

S5a

S51a

Is work machine with ESOH ≥ predetermined value present? — NO

YES

S52a

Are a plurality of work machines with ESOH ≥ predetermined value present? — NO

YES

S53a — Allocate work machine with smallest ΔSOH

S54a — Allocate work machine with ESOH ≥ predetermined value

S55a — Allocate work machine with largest ESOH

S6

NO — Has allocation been completed?

YES

End

# Fig. 3

OSM3

```
                    ┌──────────┐
                    │  Start   │
                    └──────────┘
                         │
                         ▼
        ┌──────────────────────────────────┐
        │   Store information on workload   │──── S1
        └──────────────────────────────────┘
                         │
                         ▼
        ┌──────────────────────────────────┐
        │ Acquire degradation state of battery │──── S2
        └──────────────────────────────────┘
                         │
                         ▼
        ┌──────────────────────────────────┐
        │ Predict work availability of work machine │──── S3
        └──────────────────────────────────┘
                         │
                         ▼
        ┌──────────────────────────────────┐
        │  Calculate predicted degradation state │──── S4
        │           of battery              │
        └──────────────────────────────────┘
                         │
                         ▼
```

S7

S71

Is secondhand market evaluation index satisfied? — NO

YES

S72

Salable? — NO

YES

S73 — Record work machine for sale

S5b — Allocate work machine for sale or work machine with smallest ΔSOH

S6

Has allocation been completed? — NO

YES

End

# Fig. 4

OSM4

```
         ┌─────────┐
         │  Start  │
         └─────────┘
              │
              ▼
┌────────────────────────────────┐
│   Store information on workload │ ─── S1
└────────────────────────────────┘
              │
              ▼
┌────────────────────────────────┐
│  Acquire degradation state of  │ ─── S2
│           battery              │
└────────────────────────────────┘
              │
              ▼
┌────────────────────────────────┐
│ Predict work availability of   │ ─── S3
│         work machine           │
└────────────────────────────────┘
              │
              ▼
┌────────────────────────────────┐
│  Calculate predicted           │ ─── S4
│  degradation state of battery  │
└────────────────────────────────┘
              │
              ▼
┌────────────────────────────────┐
│ Allocate work machine with     │ ─── S5c
│        largest ESOH            │
└────────────────────────────────┘
              │
              ▼
         ◇ S6
  NO  ◇ Has allocation  ◇
      ◇ been completed? ◇
              │ YES
              ▼
         ┌─────────┐
         │   End   │
         └─────────┘
```

# Fig. 5

OSM5

Start

Store information on workload ─ S1

Acquire degradation state of battery ─ S2

Predict work availability of work machine ─ S3

Calculate predicted degradation state of battery ─ S4

S5d

S51d

Is work machine satisfying evaluation index present? ── NO

YES

S52d

Do a plurality of work machines satisfy evaluation index? ── NO

YES ─ S53d │ S54d │ S55d

Allocate work machine with largest ESOH

Allocate work machine satisfying evaluation index

Allocate work machine with smallest ΔSOH

S6

NO ── Has allocation been completed?

YES

End

## INTERNATIONAL SEARCH REPORT

| International application No. |
| --- |
| **PCT/JP2024/002808** |

**A. CLASSIFICATION OF SUBJECT MATTER**

*G06Q 10/0631*(2023.01)i; *E02F 9/00*(2006.01)i; *G06Q 50/08*(2012.01)i
FI: G06Q10/0631; E02F9/00 C; G06Q50/08

According to International Patent Classification (IPC) or to both national classification and IPC

**B. FIELDS SEARCHED**

Minimum documentation searched (classification system followed by classification symbols)

G06Q10/00 - 99/00; E02F9/00

Documentation searched other than minimum documentation to the extent that such documents are included in the fields searched

Published examined utility model applications of Japan 1922-1996
Published unexamined utility model applications of Japan 1971-2024
Registered utility model specifications of Japan 1996-2024
Published registered utility model applications of Japan 1994-2024

Electronic data base consulted during the international search (name of data base and, where practicable, search terms used)

**C. DOCUMENTS CONSIDERED TO BE RELEVANT**

| Category* | Citation of document, with indication, where appropriate, of the relevant passages | Relevant to claim No. |
| --- | --- | --- |
| A | JP 2016-84633 A (HITACHI CONSTRUCTION MACHINERY CO., LTD.) 19 May 2016 (2016-05-19)<br>entire text | 1-8 |
| A | WO 2020/137553 A1 (HITACHI CONSTRUCTION MACHINERY CO., LTD.) 02 July 2020 (2020-07-02)<br>entire text | 1-8 |
| A | WO 2021/192043 A1 (HONDA MOTOR CO., LTD.) 30 September 2021 (2021-09-30)<br>entire text | 1-8 |
| A | US 2019/0370712 A1 (PALANTIR TECHNOLOGIES INC.) 05 December 2019 (2019-12-05)<br>entire text | 1-8 |

☐ Further documents are listed in the continuation of Box C.   ☑ See patent family annex.

| | | |
| --- | --- | --- |
| * | Special categories of cited documents: | |
| "A" | document defining the general state of the art which is not considered to be of particular relevance | "T" later document published after the international filing date or priority date and not in conflict with the application but cited to understand the principle or theory underlying the invention |
| "D" | document cited by the applicant in the international application | "X" document of particular relevance; the claimed invention cannot be considered novel or cannot be considered to involve an inventive step when the document is taken alone |
| "E" | earlier application or patent but published on or after the international filing date | |
| "L" | document which may throw doubts on priority claim(s) or which is cited to establish the publication date of another citation or other special reason (as specified) | "Y" document of particular relevance; the claimed invention cannot be considered to involve an inventive step when the document is combined with one or more other such documents, such combination being obvious to a person skilled in the art |
| "O" | document referring to an oral disclosure, use, exhibition or other means | "&" document member of the same patent family |
| "P" | document published prior to the international filing date but later than the priority date claimed | |

| Date of the actual completion of the international search | Date of mailing of the international search report |
| --- | --- |
| **28 March 2024** | **09 April 2024** |

| Name and mailing address of the ISA/JP | Authorized officer |
| --- | --- |
| **Japan Patent Office (ISA/JP)**<br>**3-4-3 Kasumigaseki, Chiyoda-ku, Tokyo 100-8915**<br>**Japan** | |
| | Telephone No. |

Form PCT/ISA/210 (second sheet) (July 2022)

## INTERNATIONAL SEARCH REPORT
### Information on patent family members

International application No.

**PCT/JP2024/002808**

| Patent document cited in search report | | | Publication date (day/month/year) | Patent family member(s) | | | Publication date (day/month/year) |
|---|---|---|---|---|---|---|---|
| JP | 2016-84633 | A | 19 May 2016 | (Family: none) | | | |
| WO | 2020/137553 | A1 | 02 July 2020 | (Family: none) | | | |
| WO | 2021/192043 | A1 | 30 September 2021 | US entire text | 2022/0405673 | A1 | |
| US | 2019/0370712 | A1 | 05 December 2019 | EP entire text | 3336779 | A1 | |

Form PCT/ISA/210 (patent family annex) (July 2022)

**REFERENCES CITED IN THE DESCRIPTION**

*This list of references cited by the applicant is for the reader's convenience only. It does not form part of the European patent document. Even though great care has been taken in compiling the references, errors or omissions cannot be excluded and the EPO disclaims all liability in this regard.*

**Patent documents cited in the description**

• JP 2016084633 A